# EUROPEAN PATENT APPLICATION

(11) **EP 4 611 024 A1**
(43) Date of publication of application: **03.09.2025**
(21) Application number: 23882352.0
(22) Date of filing: 02.10.2023
(51) Int. Cl.: H01L 21/60

(54) **DEVICE, ELECTRICAL DEVICE, AND SUBSTRATE**

(30) Priority: 27.10.2022 JP 2022172651
(71) Applicant: Kyocera Corporation, Kyoto-shi, Kyoto 612-8501 (JP)
(72) Inventor: TOYOTA, Daisuke, Kyoto-shi, Kyoto 612-8501 (JP); MAEDA, Kazutaka, Kyoto-shi, Kyoto 612-8501 (JP)
(74) Representative: Viering, Jentschura & Partner mbB Patent- und Rechtsanwälte
(86) International application number: PCT/JP2023/035853
(87) International publication number: WO 2024/090143

(57) **Abstract**

To secure sufficient interface strength in a solder bonding portion even after going through a high temperature process such as reflow bonding. A device has a base, an electrode comprising Ni and Cu, and a bonding portion located on the electrode. The bonding portion includes a barrier layer, a bonding layer, and a solder layer in this order from the electrode side. The barrier layer contains Mo as a main component, and the bonding layer contains at least one of Ni, Ag, Au, and Cu.

## Description

### TECHNICAL FIELD

The present disclosure relates to a device, an electrical device, and a substrate.

### BACKGROUND OF INVENTION

A device equipped with an electronic component is mounted on a mounting substrate of an electrical device by solder.

For example, an acoustic wave device described in Patent Document 1 includes a pad (electrode) provided on a piezoelectric substrate and an under-bump metal provided on the pad to facilitate bonding with solder.

### CITATION LIST

### PATENT LITERATURE

Patent Document 1: WO 2015/022931

### SUMMARY

A device according to one aspect of the present disclosure includes: a base including a first surface; an electrode located on the first surface of the base and including Ni and Cu; and a bonding portion located on the electrode, wherein the bonding portion includes a barrier layer, a bonding layer, and a solder layer in this order from the electrode side, the barrier layer includes Mo as a main component, and the bonding layer includes at least one of Ni, Ag, Au, and Cu.

### BRIEF DESCRIPTION OF THE DRAWINGS

FIG. 1 is a cross-sectional structural view of a device according to a first embodiment of the present disclosure.
FIG. 2 is a cross-sectional structural view illustrating an electronic module according to the first embodiment of the present disclosure.
FIG. 3 is a micrograph of a bonding portion according to the first embodiment of the present disclosure.
FIG. 4 is an enlarged view of a region R in FIG. 3.
FIG. 5 is a cross-sectional structural view of an acoustic wave device according to a second embodiment of the present disclosure.
FIG. 6 is a micrograph of a bonding portion of an electronic module according to Example and Comparative Example.
FIG. 7 is a graph of an evaluation result of bonding strength in Comparative Example.
FIG. 8 is a graph of the evaluation result of the bonding strength in Comparative Example.
FIG. 9 is a graph of the evaluation result of the bonding strength in Comparative Example.
FIG. 10 is a graph illustrating an evaluation result of bonding strength in Example.

### DESCRIPTION OF EMBODIMENTS

When a high temperature process such as reflow bonding is repeatedly performed, or when the device is used at a high temperature for a long time, various metal materials contained in the under-bump metal and the like react with the metal contained in the solder. As a result, the mechanical properties of the solder may deteriorate, and the interface strength of the solder bonding portion may decrease.

According to an aspect of the present disclosure, sufficient interface strength can be secured in a solder bonding portion, even after going through a high temperature process such as reflow bonding.

### First Embodiment

An embodiment of the present disclosure will be described in detail below.

### Configuration of Device and Electronic Module

Hereinafter, a configuration of a device 200 as an exemplary device according to the present disclosure will be described. The device according to the present disclosure may be, for example, an electronic device including a substrate and an electronic component such as an electronic element mounted on the substrate.

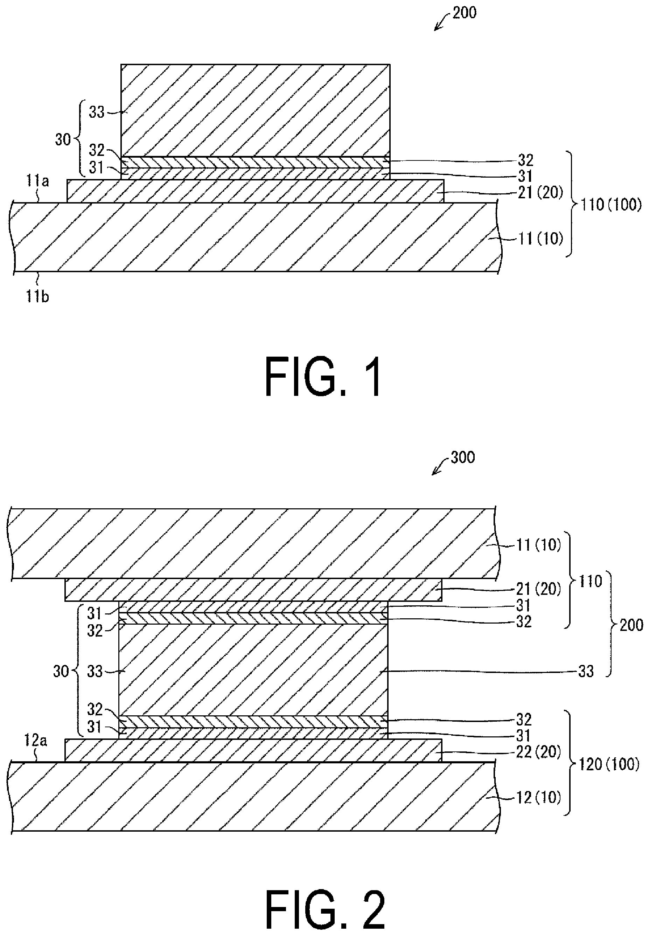

FIG. 1 is a cross-sectional structural view illustrating a part of the device 200 according to a first embodiment of the present disclosure. FIG. 1 is an enlarged cross-sectional structural view of a portion of one electrode 21 included in the device 200, and electronic components and the like included in the device 200 are not illustrated.

The device 200 includes a substrate 110 and a solder layer 33. The substrate 110 includes a base 11, an electrode 21, a barrier layer 31, and a bonding layer 32. The base 11 has the electrode 21 on a first surface 11a. In the device 200, the barrier layer 31, the bonding layer 32, and the solder layer 33 are stacked in this order from the electrode 21 side. In the device 200, the barrier layer 31, the bonding layer 32, and the solder layer 33 are referred to as a bonding portion 30. That is, the bonding portion 30 is located on the electrode 21. The barrier layer 31, the bonding layer 32, and the solder layer 33 are elements constituting the bonding portion 30.

FIG. 2 is a cross-sectional structural view illustrating a part of an electronic module 300 including the device 200. As illustrated in FIG. 2, the device 200 can constitute the electronic module 300 by being mounted on a mounting substrate (module substrate) 120. The electronic module 300 is an example of an electrical device according to the present disclosure.

In the electronic module 300, the substrate 110 of the device 200 and the mounting substrate 120 are bonded to each other via the solder layer 33. The mounting substrate 120 includes a base 12, an electrode 22, the barrier layer 31, and the bonding layer 32. The base 12 has the electrode 22 on a first surface 12a. The barrier layer 31 is located on the electrode 22, and the bonding layer 32 is located on the barrier layer 31. The barrier layer 31, the bonding layer 32, and the solder layer 33 included in the electronic module 300 are elements constituting the bonding portion 30. In other words, the bonding portion 30 is located on the electrode 22.

### Substrate, Base

The substrate 110 and the mounting substrate 120 are examples of the substrate 100 according to the present disclosure. In the following description, the substrate 110 and the mounting substrate 120 may be collectively referred to as the substrate 100 to explain what is common to the substrate 110 and the mounting substrate 120.

The substrate 110 is a substrate on which electronic components are mounted, and may include internal wires located inside the substrate 110 and through conductors that vertically connect the internal wires to each other.

The base 11 included in the substrate 110 may include a single layer or a plurality of layers. The base 11 has the first surface 11a and a second surface 11b located on the opposite side of the first surface 11a. Electronic components such as electronic elements may be mounted on the first surface 11a or the second surface 11b.

The base 11 may have an insulating property. In this case, the material of the base 11 may be, for example, a ceramic such as an aluminum nitride sintered body, an aluminum oxide sintered body (alumina ceramics), a silicon nitride sintered body, a mullite sintered body, or a glass ceramics sintered body. Alternatively, examples of the material of the base 11 include an epoxy resin, a polyimide resin, an acrylic resin, a phenol resin, and a fluorine-based resin. An example of the fluorine-based resin may be a resin such as a polyester resin and a tetrafluoroethylene resin.

The mounting substrate 120 is a circuit substrate mounted on the electronic module, and may include an electric circuit inside and/or outside the mounting substrate.

### Electrode

The electrode 21 and the electrode 22 are examples of the electrode 20 according to the present disclosure. The electrode 21 and the electrode 22 may be collectively referred to as the electrode 20 to explain the contents common to the electrode 21 and the electrode 22.

The electrode 21 included in the substrate 110 electrically connects the device 200 and the circuit substrate. The electrode 21 is located on the first surface 11a of the base 11. The substrate 110 may include a plurality of electrodes 21 on the first surface 11a.

The substrate 110 may have a metallized layer on the surface of the base 11 in addition to the electrode 21. The metallized layer includes, for example, a metallized layer that is provided in a mounting region of the base 11 in which an electronic component is mounted and that can be electrically connected to the electronic component.

In the case where the base 11 is made of an electrically insulating ceramic, the metallized layer is made of, for example, any one of W (tungsten), Mo (molybdenum), Mn (manganese), Ag (silver), Ni, and Cu, or an alloy containing at least one of these. When the base 11 is made of a resin, the metallized layer is made of, for example, any one of Cu, Au (gold), Al (aluminum), Ni, Mo, and Ti (titanium), or an alloy containing at least one of these metals. The internal wire and the through conductor also have the same configuration as the alloy of the metallized layer.

The electrode 22 included in the mounting substrate 120 electrically connects the mounting substrate 120 and an electronic device or the like. The electrode 22 is located on the first surface 12a of the base 12.

The electrode 20 may be made of an alloy containing Ni (nickel) and Cu (copper). The electrode 21 may contain a metal other than Ni and Cu.

### Barrier Layer

The barrier layer 31 is a layer containing Mo as a main component. The manufacturing process of the device 200 and the electronic module 300 includes a solder bonding process, which is a high temperature process. In a case where the barrier layer 31 and the bonding layer 32 are not provided, for example, when the flow solder bonding is performed, molten high temperature solder is applied onto the electrode 21. When the reflow bonding is performed, the device 200 or the electronic module 300 in which the solder is applied to the electrode portion is heated in a reflow furnace. In addition, the solder bonding portion may be repeatedly or continuously in a high temperature state due to heat generation in the module during use of the electronic module 300. In such a case, an electrode metal such as Cu or Ni contained in the electrode 20 is dissolved and reacts with a metal such as Sn (tin) or Cu contained in the solder, whereby a metal compound is formed. Since the metal compound is hard and brittle, it often becomes a starting point of a crack.

Since the barrier layer 31 is located between the electrode 20 and the solder layer 33, the electrode metal contained in the electrode 20 is less likely to react with the metal contained in the solder layer. In other words, the diffusion of the electrode metal into the solder layer can be reduced. This can reduce the formation of metal compounds. The thickness of the barrier layer 31 may be, for example, 0.1 µm or more. When the barrier layer 31 has a thickness of 0.1 µm or more, reaction between the electrode metal and the metal of the solder layer may be significantly less likely to occur.

### Bonding layer

The bonding layer 32 is located between the solder layer 33 and the barrier layer 31, and contains at least one of Ni, Ag, Au, and Cu. Due to the presence of the bonding layer 32, the wettability of the solder is ensured, so that the interface strength of the solder interface can be improved.

The bonding layer 32 may contain Ni, a Ni-Sn compound, Cu, or a Cu-Sn compound as a main component. Ni and Cu have excellent wettability for solder, which further improves the interface strength.

In the state of the substrate 100 before solder bonding is performed, the thickness of the bonding layer 32 may be smaller than the thickness of the electrode 20. For example, the thickness of the bonding layer 32 may be 0.1 µm or more and 1 µm or less, and may be 0.1 µm.

In a high temperature state such as solder bonding, the metal contained in the bonding layer 32 and the metal contained in the solder may react with each other to form a metal compound. By setting the thickness of the bonding layer 32 to the above-described thickness, the amount of metal eluted from the bonding layer 32 at the time of solder bonding or the like can be reduced, and the amount of the metal compound formed can be reduced. In addition, since the amount of metal eluted from the sufficiently thin bonding layer 32 is small, coarse particles of the metal compound are less likely to be formed, and the bonding layer 32 is less likely to become brittle. That is, the bonding portion 30 having excellent interface strength while ensuring the wettability of the solder can be achieved.

### Solder Layer

The solder layer 33 is a layer containing a metal such as Sn, Ag, or Cu.

### Bonding Layer in Device or Electronic Module

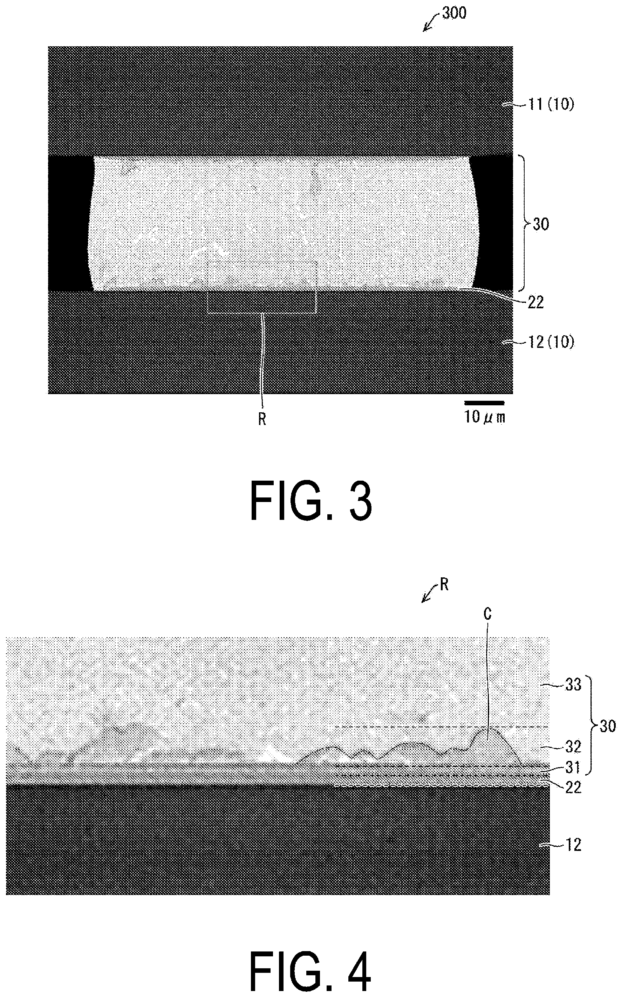

FIG. 3 is a micrograph of the bonding portion 30 in the electronic module 300 illustrated in FIG. 2. FIG. 4 is an enlarged view of a region R in FIG. 3. The micrographs illustrated in FIGs. 3 and 4 are photographs of an electronic module 300 in which solder bonding was performed in a reflow furnace. In the device 200 and the electronic module 300, the solder layer 33 is melted when heated at the time of solder bonding in the manufacturing process. At this time, at least a part of the metal of the bonding layer 32 reacts with the metal contained in the solder layer 33 to form one or more compounds. The region C in FIG. 4 is a region containing a large amount of the compound. Examples of the one or more compounds include a Ni-Sn compound and a Cu-Sn compound.

For example, when the bonding layer 32 before solder bonding contains Ni as a main component, the region C contains at least one compound selected from the group consisting of Ni₃Sn₄, Ni₃Sn₂, Ni₃Sn, (Cu, Ni)₃ Sn₄, and (Cu, Ni)₆Sn₅.

As described above, in the device 200 or the electronic module 300, the bonding layer 32 may contain Ni, a Ni-Sn compound, Cu, or a Cu-Sn compound as a main component.

As illustrated in FIG. 4, the bonding layer 32 may be a layer defined between the upper surface of the barrier layer 31 and a surface that is substantially parallel to the upper surface of the barrier layer 31 and located at the top of the region C. Alternatively, it may be a layer defined between the upper surface of the barrier layer 31 and the boundary of the region C on the solder layer side. In this case, the bonding layer 32 may be a layer having unevenness, or may have a hole in a part thereof.

As described above, the substrate 100 includes the barrier layer 31 and the bonding layer 32, and thus can reduce the amount of the compound containing Sn formed in the vicinity of the interface between the solder layer 33 and the bonding layer 32 while ensuring the wettability of the solder at the time of solder bonding. As a result, the substrate 100 makes it possible to provide a device or an electronic module having a sufficient interface strength in the solder bonding portion even after going through a high temperature process such as reflow bonding.

In addition, the device 200 and the electronic module 300 include the substrate 100 and the bonding portion 30, and thus can secure a sufficient interface strength in the solder bonding portion even after going through a high temperature process such as reflow bonding.

### Second Embodiment

Another embodiment of the present disclosure will be described below. For convenience of description, members having the same functions as those of the members described in the above-described embodiment are denoted by the same reference signs, and description thereof is not repeated.

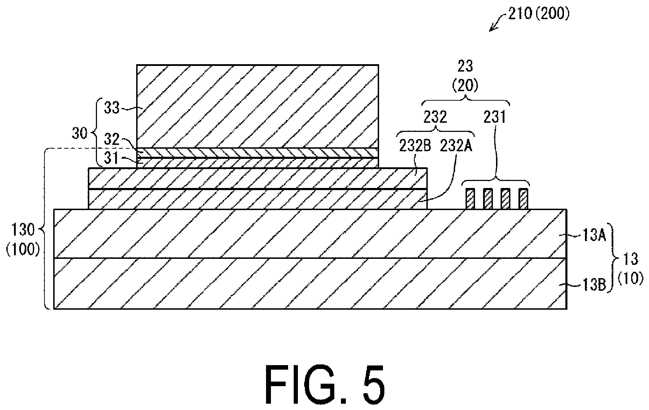

In the second embodiment, an example in which the device 200 is an acoustic wave device will be described. FIG. 5 is a cross-sectional structural view of an acoustic wave device 210 according to a second embodiment of the present invention.

The acoustic wave device 210 includes a substrate 130 and the solder layer 33. The substrate 130 includes a base 13, an electrode layer 23, the barrier layer 31, and the bonding layer 32. The acoustic wave device 210 may be mounted on a circuit substrate (mounting substrate) of a communication equipment.

The base 13 includes a piezoelectric layer 13A and a support substrate 13B that supports the piezoelectric layer 13A. The piezoelectric layer 13A has a first surface 13a located on a side opposite to a surface bonded to the support substrate 13B. The electrode layer 23 is provided on the first surface 13a of the piezoelectric layer 13A. In the acoustic wave device 210, the barrier layer 31, the bonding layer 32, and the solder layer 33 are stacked in this order from the electrode layer 23 side. In the acoustic wave device 210, the barrier layer 31, the bonding layer 32, and the solder layer 33 are collectively referred to as the bonding portion 30. That is, the bonding portion 30 is located on the electrode layer 23. The barrier layer 31, the bonding layer 32, and the solder layer 33 are elements constituting the bonding portion 30. The base 13 is not limited to the above configuration. For example, the base 13 may not include the support substrate 13B. In this case, the piezoelectric layer 13A itself also serves as the support substrate 13B.

The base 13 is an example of the base 10 according to the present disclosure, and the substrate 130 is an example of the substrate 100 according to the present disclosure.

The electrode layer 23 includes an interdigital transducer (IDT) electrode 231 and a pad portion 232. The pad portion 232 includes a first pad 232A and a second pad 232B. The pad portion 232 in the present embodiment is an example of the electrode 20 according to the present disclosure. The first pad 232A and the second pad 232B are stacked in this order from the base 13 side. That is, the pad portion 232 may include a plurality of layers. The first pad 232A may have the same thickness as the IDT electrode 231. Since the pad portion 232 has a stacked structure, the electrical resistance can be reduced.

The IDT electrode 231 is a comb-shaped electrode that generates an acoustic wave in the acoustic wave device. The IDT electrode 231 includes a pair of electrodes to which an AC voltage is applied. The IDT electrode 231 is electrically connected to the pad portion 232.

The acoustic wave device 210 is characterized in that the number of bonding parts bonded via the bonding portion 30 is small as compared with other electronic devices. Therefore, securing the interface strength in the bonding portion 30 is important. The acoustic wave device 210 includes the substrate 130 and the bonding portion 30, and thus can ensure a sufficient interface strength in the solder bonding portion even after going through a high temperature process such as reflow bonding.

In the second embodiment, a surface acoustic wave (SAW) is described as an acoustic wave device, but the present invention is not limited thereto. The acoustic wave device may be, for example, a bulk acoustic wave (BAW).

### Demonstration Test

Hereinafter, a demonstration test for demonstrating the effects of the substrate, the device, and the electrical device of the present disclosure will be described.

### Demonstration Test 1: Comparison by Microscope

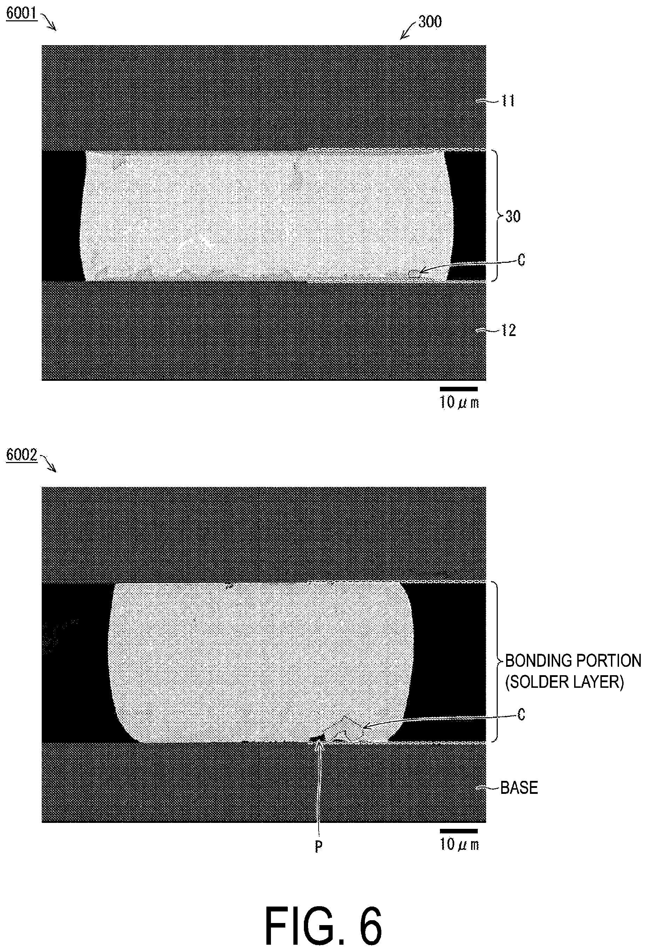

FIG. 6 is a micrograph of a bonding portion of an electronic module. Reference numeral 6001 in FIG. 6 is a micrograph of the bonding portion 30 in the electronic module 300 according to an example of the present disclosure. Reference numeral 6002 in FIG. 6 is a micrograph of a bonding portion of an electronic module as Comparative Example. In the electronic module of Comparative Example, the solder layer is located between the electrode on the electronic device side and the mounting substrate. That is, the barrier layer 31 and the bonding layer 32 according to the present disclosure are not included. The heating conditions at the time of solder bonding were the same for Example and Comparative Example.

In Comparative Example indicated by reference numeral 6002 in FIG. 6, a region C containing a large amount of a compound formed by a reaction between the electrode metal and the metal contained in the solder layer is present as a coarse granular region in the vicinity of the interface of the bonding portion. In addition, since a large amount of the electrode metal is eluted to the solder layer side, a void P is formed at the interface of the bonding portion.

On the other hand, in the electronic module 300 according to the present disclosure indicated by the reference numeral 6001 in FIG. 6, the region C present in the vicinity of the interface of the bonding portion 30 is relatively small. In addition, the void P observed in Comparative Example was not observed.

That is, it was demonstrated that, by having the barrier layer 31 and the bonding layer 32 according to the present disclosure, the formation of a brittle compound in the solder bonding portion can be significantly reduced even after going through a high temperature process such as reflow bonding. In addition, it was also demonstrated that since the elution of the electrode metal to the solder layer side is reduced, a gap is less likely to be generated at the interface between the electrode and the bonding portion.

From the above, it was demonstrated that the substrate, the device, and the electrical device according to the present disclosure can secure sufficient interface strength in the solder bonding portion even after going through a high temperature process or the like.

### Demonstration Test 2: Bonding Strength Test

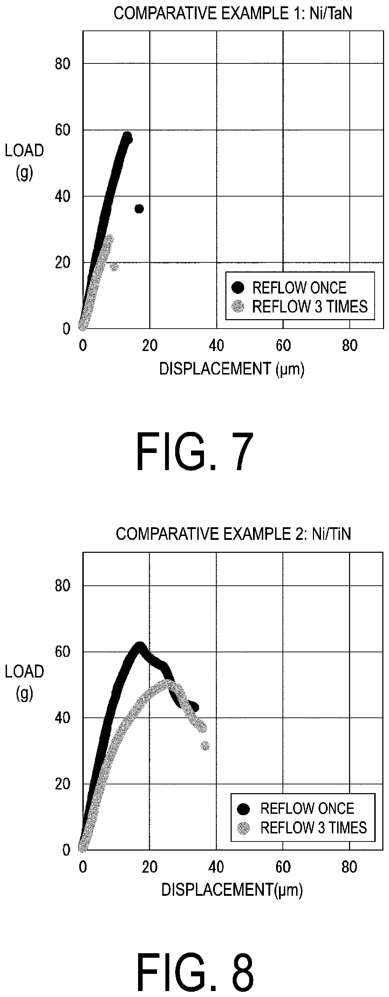

FIGs. 7 to 10 are graphs of the results of evaluating the bonding strength when the metal used for the barrier layer is changed. The evaluation test of the bonding strength was performed in accordance with the standard of solder ball shear of JEDEC JESD22-B117.

In Comparative Example 1, a Ni layer as an electrode and a TaN (tantalum nitride) layer as a barrier layer were laminated on a substrate, and a solder ball was placed thereon.

FIG. 7 illustrates the results of a test performed on the configuration of Comparative Example 1 after the reflow treatment was performed once and a test performed thereon after the reflow treatment was performed three times.

In Comparative Example 2, a Ni layer as an electrode and a TiN (titanium nitride) layer as a barrier layer were stacked on a substrate, and a solder ball was placed thereon. FIG. 8 illustrates the results for Comparative Example 2.

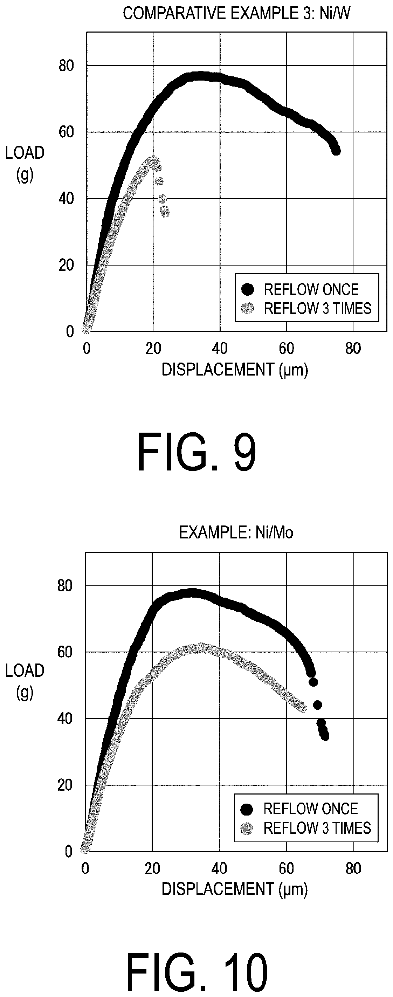

In Comparative Example 3, a Ni layer as an electrode and a W (tungsten) layer as a barrier layer were laminated on a substrate, and a solder ball was placed thereon. FIG. 9 illustrates the results for Comparative Example 3.

In Example, a Ni layer as an electrode and a Mo (molybdenum) layer, which is the same as the barrier layer 31 of the present disclosure, as a barrier layer were laminated on a substrate, and a solder ball was placed thereon. FIG. 10 illustrates the results for Example.

In Comparative Example 1 and Comparative Example 2, the graph illustrates that the load sharply drops at a relatively small displacement in any of the cases of one reflow treatment and three reflow treatments. This indicates that the interface strength is weak, and peeling occurs at the solder interface at the displacement at which the load rapidly dropped.

In Comparative Example 3, in the case of one reflow treatment, the graph does not show that the load sharply drops within the test range of the displacement. The gradual drop in load indicates that bulk failure of the solder, rather than delamination. However, in the result of the case where the reflow treatment is performed three times, the graph illustrates that the load sharply drops at a small displacement. That is, this indicates that the interface strength was weakened by the repetition of the reflow treatment.

On the other hand, in Example, the graph does not show that the load sharply drops within the test range of the displacement in any of the cases of one reflow treatment and three reflow treatments. That is, it was demonstrated that the interface strength was maintained within the test range of displacement.

From the above test results, it was demonstrated that by using the Mo layer as the barrier layer 31, sufficient interface strength can be ensured in the solder bonding portion even after going through a high temperature process such as reflow bonding.

### Conclusion

(1) A device according to a first aspect of the present disclosure: a base including a first surface; an electrode located on the first surface of the base and including Ni and Cu; and a bonding portion located on the electrode, wherein the bonding portion includes a barrier layer, a bonding layer, and a solder layer in this order from the electrode side, the barrier layer includes Mo as a main component, and the bonding layer includes at least one of Ni, Ag, Au, and Cu.
(2) A device according to a second aspect of the present disclosure is the device according to the first aspect, wherein the barrier layer has a thickness of 0.1 µm or more.
(3) A device according to a third aspect of the present disclosure is the device according to the first or second aspect, wherein the bonding layer contains Ni, a Ni-Sn compound, Cu, or a Cu-Sn compound as a main component.
(4) A device according to a fourth aspect of the present disclosure is the device according to any one of the first to third aspects, wherein the electrode is provided on the piezoelectric layer and connected to the IDT electrode.
(5) An electrical device according to a fifth aspect of the present disclosure includes the device according to any one of the first to fourth aspects of the present disclosure.
(6) A substrate according to a sixth aspect of the present disclosure includes: a base including a first surface; an electrode located on the first surface of the base and including Ni and Cu; a barrier layer located on the electrode; and a bonding layer located on the barrier layer, wherein the barrier layer includes Mo as a main component, and the bonding layer includes at least one of Ni, Ag, Au, and Cu.
(7) A substrate according to a seventh aspect of the present disclosure is the substrate according to sixth aspect, wherein a thickness of the bonding layer is smaller than a thickness of the electrode.
(8) A substrate of an eighth aspect of the present disclosure is the substrate according to sixth or seventh aspect, wherein the bonding layer has a thickness of 0.1 µm or more and 1 µm or less.

The invention according to the present disclosure has been described above based on the drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, it should be noted that a person skilled in the art can easily make different variations or modifications based on the present disclosure. It should also be noted that these variations or modifications are within the scope of the present disclosure.

### REFERENCE SIGNS

10, 11, 12, 13 Base
20, 21, 22 Electrode
30 Bonding portion
31 Barrier layer
32 Bonding layer
100, 110, 130 Substrate
120 Mounting substrate
200 Device
210 Acoustic wave device (device)
13A Piezoelectric layer
13B Support substrate
23 Electrode layer
231 IDT electrode
232 Pad portion (electrode)
300 Electronic module (electrical device)

## Claims

1. A device comprising:
a base comprising a first surface;
an electrode located on the first surface of the base and comprising Ni and Cu; and
a bonding portion located on the electrode, wherein
the bonding portion comprises a barrier layer, a bonding layer, and a solder layer in this order from the electrode side,
the barrier layer comprises Mo as a main component, and
the bonding layer comprises at least one of Ni, Ag, Au, and Cu.

2. The device according to claim 1, wherein
the barrier layer has a thickness of 0.1 µm or more.

3. The device according to claim 1 or 2, wherein
the bonding layer comprises Ni, a Ni-Sn compound, Cu, or a Cu-Sn compound as a main component.

4. The device according to any one of claims 1 to 3, wherein
the electrode is provided on a piezoelectric layer and is connected to an IDT electrode.

5. An electrical device comprising the device according to any one of claims 1 to 4.

6. A substrate comprising:
a base comprising a first surface;
an electrode located on the first surface of the base and comprising Ni and Cu;
a barrier layer located on the electrode; and
a bonding layer located on the barrier layer, wherein
the barrier layer comprises Mo as a main component, and
the bonding layer comprises at least one of Ni, Ag, Au, and Cu.

7. The substrate according to claim 6, wherein
a thickness of the bonding layer is smaller than a thickness of the electrode.

8. The substrate according to claim 6 or 7, wherein
the bonding layer has a thickness of 0.1 µm or more and 1 µm or less.
